# EUROPEAN PATENT APPLICATION

(11) **EP 4 835 979 A1**
(43) Date of publication of application: **04.11.2026**
(21) Application number: 24910076.9
(22) Date of filing: 26.09.2024
(51) Int. Cl.: H01M 4/131, H01M 4/62, H01M 10/052, H01M 10/0562, H01M 10/0565, G01N 27/416, G01B 21/02, G01R 31/00

(54) **POSITIVE ELECTRODE PLATE, METHOD FOR EVALUATING ELECTROCHEMICAL PERFORMANCE OF POSITIVE ELECTRODE PLATE, SOLID-STATE BATTERY, AND ELECTRIC DEVICE**

(30) Priority: 29.12.2023 CN 202311871551
(71) Applicant: BYD Company Limited, Shenzhen, Guangdong 518118 (CN)
(72) Inventor: WANG, Guoshuai, Shenzhen, Guangdong 518118 (CN); YI, Guangui, Shenzhen, Guangdong 518118 (CN); GUO, Zizhu, Shenzhen, Guangdong 518118 (CN)
(74) Representative: Wu, Ting
(86) International application number: PCT/CN2024/121574
(87) International publication number: WO 2025/139132

(57) **Abstract**

A positive electrode plate, a method for evaluating the electrochemical performance of a positive electrode plate, a solid-state battery, and an electric device. A positive electrode active material layer of the positive electrode plate includes a positive electrode active material and a positive electrode electrolyte, and there are pores in the positive electrode active material layer. In the vertical section of the positive electrode active material layer, the total length of the contact interface between the positive electrode active material and the positive electrode electrolyte is defined as the total length L1 of a first contact interface, the total length of the contact interface between the positive electrode active material and the positive electrode active material is defined as the total length L2 of a second contact interface, and the total length of the contact interface between the positive electrode active material and the pores is defined as the total length L3 of a third contact interface. The length ratio of L1, L2 and L3 satisfies: L1:L2:L3 = (80-99):(1-20):(0-5), wherein L1, L2, and L3 are defined on a normalized scale in which their sum is taken as 100. The positive electrode plate has excellent comprehensive electrochemical performance, and the evaluation method involves a simple process and has a wide application range, and can be used to rapidly evaluate the electrochemical performance of a positive electrode plate.

## Description

### CROSS-REFERENCE TO RELATED APPLICATIONS

The present disclosure claims priority to Chinese Patent Application No. 202311871551.0 filed on December 29, 2023, entitled "POSITIVE ELECTRODE PLATE, METHOD FOR EVALUATING ELECTROCHEMICAL PERFORMANCE OF POSITIVE ELECTRODE PLATE, SOLID-STATE BATTERY, AND ELECTRIC DEVICE", which is incorporated herein by reference in its entirety.

### FIELD

The present disclosure relates to the field of batteries, in particular to a positive electrode plate, a method for evaluating an electrochemical performance of a positive electrode plate, a solid-state battery, and an electric device.

### BACKGROUND

At present, solid-state batteries are concerned due to high energy density and high safety. In the solid-state battery, the contact between internal solid particles in the positive electrode plate determines the construction of ion pathways and electron pathways, thereby directly affecting the electrical performance of the solid-state battery. In the related technology, most attention is focused on the contact between the positive electrode plate and the solid-state electrolyte layer, the contact state of the internal particles in the positive electrode active material layer of the positive electrode plate is ignored, and there is no effective method to evaluate the construction of the ion pathways and the electron pathways in the positive electrode active material layer.

### SUMMARY

In view of this, the present disclosure provides a positive electrode plate, a method for evaluating an electrochemical performance of a positive electrode plate, a solid-state battery, and an electric device. The positive electrode plate has low resistance, high specific capacity and high ionic conductivity, and has excellent electrochemical performance, which is conducive to improving the performance of the solid-state battery. The method for evaluating the electrochemical performance of the positive electrode plate is simple, has a wide range of applications, classifies and evaluates the contact state of the internal particles in the positive electrode plate, ensures good ionic conduction pathway and excellent specific capacity, and improves the electrochemical performance of the positive electrode plate.

In a first aspect, the present disclosure provides a positive electrode plate, the positive electrode plate includes a positive electrode current collector and a positive electrode active material layer arranged on a surface of the positive electrode current collector, the positive electrode active material layer includes a positive electrode active material and a positive electrode electrolyte, and pores exist in the positive electrode active material layer;
at least one vertical section of the positive electrode active material layer is taken, and it is defined that in the at least one vertical section, a total length of a contact interface between the positive electrode active material and the positive electrode electrolyte is a total length L₁ of a first type of contact interface, a total length of a contact interface between the positive electrode active material and the positive electrode active material is a total length L₂ of a second type of contact interface, and a total length of a contact interface between the positive electrode active material and the pores is a total length L₃ of a third type of contact interface;
wherein a length ratio of the total length L₁ of the first type of contact interface, the total length L₂ of the second type of contact interface, and the total length L₃ of the third type of contact interface satisfies: L₁:L₂:L₃=(80-99):(1-20):(0-5), and wherein L1, L2, and L3 are defined on a normalized scale in which their sum is taken as 100.

In an embodiment of the present disclosure, the length ratio of the total length L₁ of the first type of contact interface, the total length L₂ of the second type of contact interface, and the total length L₃ of the third type of contact interface satisfies: L₁:L₂:L₃=(85-95):(5-15):(0-2), and wherein L1, L2, and L3 are defined on a normalized scale in which their sum is taken as 100.

In an embodiment of the present disclosure, the mass percentage of the positive electrode active material in the positive electrode active material layer ranges from 50% to 90%, and the mass percentage of the positive electrode electrolyte in the positive electrode active material layer ranges from 10% to 50%.

In an embodiment of the present disclosure, the volume percentage of the pores in the positive electrode active material layer is less than or equal to 5%, and a pore size of the pores ranges from 0.1 µm to 5 µm.

In an embodiment of the present disclosure, the positive electrode active material includes at least one of lithium iron phosphate, lithium cobalt oxide, lithium manganese oxide, lithium nickel cobalt aluminum oxide, lithium nickel cobalt manganese oxide, and lithium nickel manganese oxide, and the positive electrode electrolyte includes at least one of an oxide electrolyte, a sulfide electrolyte, and a polymer electrolyte.

In an embodiment of the present disclosure, the sulfide electrolyte includes at least one of Li₃PS₄, Li_{5.5}PS_{4.5}Cl_{1.5}, Li₇P₃S₁₁, Li₁₁GeP₂S₁₂, Li₆PS₅Cl, Li₇P₂S₈I, Li₁₀SnP₂S₁₂ and Li3.25Ge0.25P0.75S4.

In the positive electrode plate provided by the present disclosure, by controlling the three types of contact in the positive electrode active material layer-the contact between the positive electrode active material and the positive electrode electrolyte, the contact between the positive electrode active material and the positive electrode active material, and the contact between the positive electrode active material and the pores-within a suitable proportion range, a large number of ionic conduction pathways can be formed in the positive electrode plate, thereby improving ionic conductivity, which is conducive to increasing the specific capacity of the positive electrode plate and improving the electrochemical performance of the positive electrode plate.

In a second aspect, the present disclosure provides a method for evaluating an electrochemical performance of a positive electrode plate, including:
a positive electrode plate is provided, the positive electrode plate includes a positive electrode current collector and a positive electrode active material layer arranged on a surface of the positive electrode current collector, the positive electrode active material layer includes a positive electrode active material and a positive electrode electrolyte, and pores exist in the positive electrode active material layer;
the positive electrode plate is cut along a thickness direction of the positive electrode plate to obtain a vertical section of the positive electrode active material layer; at least one vertical section of the positive electrode active material layer is taken, and it is defined that in the at least one vertical section, a total length of a contact interface between the positive electrode active material and the positive electrode electrolyte is a total length L₁ of a first type of contact interface, a total length of a contact interface between the positive electrode active material and the positive electrode active material is a total length L₂ of a second type of contact interface, and a total length of a contact interface between the positive electrode active material and the pores is a total length L₃ of a third type of contact interface;
the total length L₁ of the first type of contact interface, the total length L₂ of the second type of contact interface, and the total length L₃ of the third type of contact interface in the vertical section of the positive electrode active material layer are acquired by a characterization means, and a ratio L₁:L₂:L₃ of the total length L₁ of the first type of contact interface, the total length L₂ of the second type of contact interface, and the total length L₃ of the third type of contact interface is calculated, and the electrochemical performance of the positive electrode plate is evaluated by determining whether L₁:L₂:L₃ satisfies L₁:L₂:L₃ = (80-99):(1-20):(0-5), and wherein L1, L2, and L3 are defined on a normalized scale in which their sum is taken as 100.

The method for evaluating the electrochemical performance of the positive electrode plate provided by the present disclosure is novel, has a simple evaluation process and a wide range of application, and can quickly evaluate the electrochemical performance of the positive electrode plate.

In a third aspect, the present disclosure provides a positive electrode plate, the positive electrode plate includes a positive electrode active material layer, the positive electrode active material layer includes a positive electrode active material and a positive electrode electrolyte, and pores exist in the positive electrode active material layer;
it is defined that, in the positive electrode active material layer, a total area of a contact interface between the positive electrode active material and the positive electrode electrolyte is a total area S₁ of a first type of contact interface, a total area of a contact interface between the positive electrode active material and the positive electrode active material is a total area S₂ of a second type of contact interface, and a total area of a contact interface between the positive electrode active material and the pores is a total area S₃ of a third type of contact interface;
wherein an area ratio of the total area S₁ of the first type of contact interface, the total area S₂ of the second type of contact interface, and the total area S₃ of the third type of contact interface satisfies: S₁:S₂:S₃ = (80-99):(1-20):(0-5), and wherein S1, S2, and S3 are defined on a normalized scale in which their sum is taken as 100.

In the positive electrode plate provided by the present disclosure, by controlling the three types of contact in the positive electrode active material layer-the contact between the positive electrode active material and the positive electrode electrolyte, the contact between the positive electrode active material and the positive electrode active material, and the contact between the positive electrode active material and the pores-within a suitable proportion range, a large number of ionic conduction pathways can be formed in the positive electrode plate, thereby improving ionic conductivity, which is conducive to increasing the specific capacity of the positive electrode plate and improving the electrochemical performance of the positive electrode plate.

In a fourth aspect, the present disclosure provides a solid-state battery, the solid-state battery includes a positive electrode plate and a solid-state electrolyte layer arranged on a surface of the positive electrode plate, and the positive electrode plate includes the positive electrode plate according to the first aspect or the third aspect.

In an embodiment of the present disclosure, the solid-state electrolyte layer includes at least one of an oxide electrolyte, a sulfide electrolyte, and a polymer electrolyte.

The solid-state battery provided by the present disclosure has excellent electrochemical performance and high safety performance, which is conducive to the widespread application of solid-state batteries.

In a fifth aspect, the present disclosure provides an electric device, and the electric device includes the solid-state battery according to the fourth aspect.

The electric device provided by the present disclosure has excellent comprehensive performance and strong market competitiveness.

### BRIEF DESCRIPTION OF THE DRAWINGS

In order to more clearly illustrate the technical solutions in the embodiments of the present disclosure or the prior art, the following briefly describes the accompanying drawings that need to be used in the embodiments or the prior art description. The specific embodiments described herein are only used to explain the present disclosure, and are not used to limit the present disclosure.
FIG. 1 is a schematic diagram of a section of a positive electrode plate provided by an embodiment of the present disclosure;
FIG. 2 is an enlarged view of the dashed line area in FIG. 1;
FIG. 3 is a schematic diagram of a section structure of a solid-state battery provided by an embodiment of the present disclosure;
FIG. 4 is a scanning electron microscope (SEM) image of a section of a positive electrode active material layer provided by Example 1 of the present disclosure.

### DETAILED DESCRIPTION

The technical solutions in the embodiments of the present disclosure will be clearly and completely described below in combination with the accompanying drawings in the embodiments of the present disclosure. Obviously, the described embodiments are only part of the embodiments of the present disclosure, rather than all the embodiments. Based on the embodiments in the present disclosure, all the other embodiments acquired by a person skilled in the art without creative labor are within the protection scope of the present disclosure.

In the related art, most attention is focused on the contact between the positive electrode plate and the solid-state electrolyte layer in the solid-state batteries, thereby ensuring the ionic conduction pathway between the positive electrode plate and the solid-state electrolyte layer. However, for the positive electrode active material layer of the positive electrode plate, how to determine the contact state of the internal particles in the positive electrode active material layer and how to ensure the effective construction of the ion pathways and the electron pathways of the positive electrode active material layer have not been reported, and the problems of increased resistance, reduced specific capacity and decreased electrochemical performance of the solid-state battery caused by the unbalanced construction of the ion pathways and the electron pathways of the positive electrode plate still exist.

To solve the above technical problem, the present disclosure provides a positive electrode plate and a method for evaluating an electrochemical performance of a positive electrode plate, the positive electrode plate has the advantages of low resistance, high specific capacity and high ionic conductivity, and has excellent comprehensive performance; the method for evaluating the electrochemical performance of the positive electrode plate is simple, the contact state of the internal particles in the positive electrode active material layer in the positive electrode plate is classified and evaluated, and the electrochemical performance of the positive electrode plate can be further quickly and effectively evaluated.

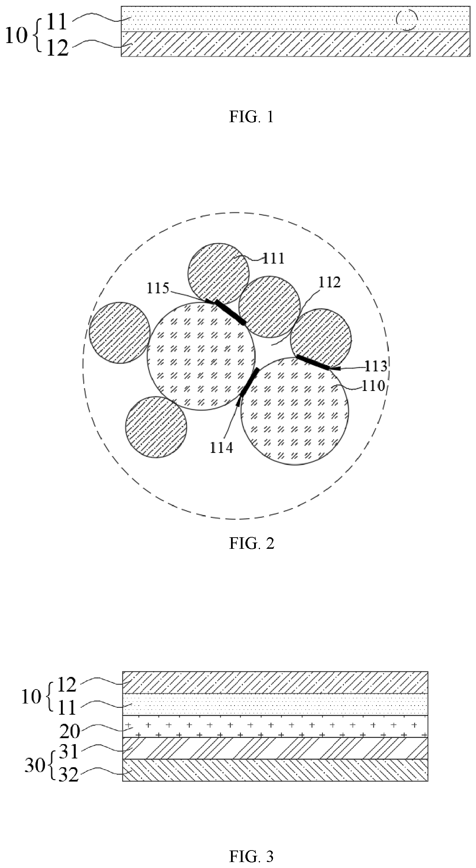

Referring to FIG. 1 and FIG. 2, FIG. 1 is a schematic diagram of a section of a positive electrode plate provided by an embodiment of the present disclosure, and FIG. 2 is an enlarged view of a dashed line area in FIG. 1. A positive electrode plate 10 includes a positive electrode current collector 12 and a positive electrode active material layer 11 arranged on the surface of the positive electrode current collector 12. The positive electrode active material layer 11 includes a positive electrode active material 110 and a positive electrode electrolyte 111, and pores 112 exist in the positive electrode active material layer. It is defined that a contact interface between the positive electrode active material 110 and the positive electrode electrolyte 111 is a first type of contact interface 113, a contact interface between the positive electrode active material 110 and the positive electrode active material 110 is a second type of contact interface 114, and a contact interface between the positive electrode active material 110 and the pores 112 is a third type of contact interface 115. At least one vertical section of the positive electrode active material layer is taken, and it is defined that in the at least one vertical section, a total length of the contact interface between the positive electrode active material 110 and the positive electrode electrolyte 111, i.e., the total length of the first type of contact interface 113 is the total length L₁ of the first type of contact interface, a total length of the contact interface between the positive electrode active material 110 and the positive electrode active material 110, i.e., the total length of the second type of contact interface 114 is the total length L₂ of the second type of contact interface, and a total length of the contact interface between the positive electrode active material 110 and the pores 112, i.e., the total length of the third type of contact interface 115 is the total length L₃ of the third type of contact interface, wherein a length ratio of L₁:L₂:L₃ satisfies: L₁:L₂:L₃ = (80-99):(1-20):(0-5), and wherein L1, L2, and L3 are defined on a normalized scale in which their sum is taken as 100.

The positive electrode plate provided by the present disclosure has a high proportion of the total length L₁ of the first type of contact interface, i.e., the contact interface between the positive electrode active material and the positive electrode electrolyte in the active material layer is relatively large, the ion transfer occurs widely, the pathways for ion intercalation and deintercalation are increased, and the ionic conductivity and specific capacity of the positive electrode plate are improved; the appropriate total length L₂ of the second type of contact interface, i.e., the appropriate contact interface formed between the positive electrode active materials, provides an appropriate number of electronic conduction pathways, and maintains a low resistance of the positive electrode plate; the total length L₃ of the third type of contact interface reflects the contact state between the positive electrode active material and the pores, the contact cannot participate in the construction of the electronic conduction and ionic conduction pathways, is an ineffective contact, and cannot effectively affect the electrochemical performance of the positive electrode plate, and the proportion of the total length L₃ of the third type of contact interface is controlled to be relatively low, which is conducive to improving the performance of the positive electrode plate. In the positive electrode plate provided by the present disclosure, by controlling the proportion range of three types of contacts in the positive electrode active material layer, i.e., the contact between the positive electrode active material and the positive electrode electrolyte, the contact between the positive electrode active material and the positive electrode active material layer, and the contact between the positive electrode active material layer and the pores, the number of ionic conduction pathways in the positive electrode plate can be increased, the appropriate number of electronic conduction pathways can be controlled, the ionic conductivity and specific capacity are improved, the resistance of the positive electrode plate is reduced, and thus the comprehensive electrochemical performance of the positive electrode plate is improved.

In the present disclosure, at least one vertical section of the positive electrode active material layer is taken to perform proportion statistics of the total length of the first type of contact interface, the total length of the second type of contact interface, and the total length of the third type of contact interface. The at least one vertical section can be one or more (two or more) vertical sections. Taking a plurality of sections of the positive electrode active material layer to perform the statistics of the total length of the first type of contact interface, the total length of the second type of contact interface, and the total length of the third type of contact interface is conducive to obtaining the positive electrode active material layer with more excellent performance. Specifically, the number of the vertical sections of the positive electrode active material layer taken can be but is not limited to 1, 2, 3, 5, 8, 10, 15, 20, or 50, etc. In an embodiment of the present disclosure, the number of the vertical sections of the positive electrode active material layer taken can range from 2 to 10.

It should be noted that when the plurality of vertical sections are taken, the total length L₁ of the first type of contact interface is acquired by adding the lengths of all the first type of contact interfaces 113 in the plurality of vertical sections; the total length L₂ of the second type of contact interface is acquired by adding the lengths of all the second type of contact interfaces 114 in the plurality of vertical sections; and the total length L₃ of the third type of contact interface is acquired by adding the lengths of all the third type of contact interfaces 115 in the plurality of vertical sections. When the plurality of vertical sections are taken, the plurality of vertical sections can be uniformly spaced and distributed in the positive electrode active material layer.

In the present disclosure, it is defined that in the at least one vertical section, the total length of the contact interface between the positive electrode active material and the positive electrode electrolyte is the total length L₁ of the first type of contact interface. In the positive electrode active material layer, the positive electrode active material and the positive electrode electrolyte are in contact with each other, and the contact position is the main position where ion transfer occurs, i.e., the larger the contact area, the higher the ion mobility and the higher the ionic conductivity. For convenience of characterization, the present disclosure uses the length of the contact interface between the positive electrode active material and the positive electrode electrolyte in the vertical section of the positive electrode active material layer to evaluate, and statistically calculates the total length of the contact interface between the positive electrode active material and the positive electrode electrolyte in the vertical section to reflect the contact state between the positive electrode active material and the positive electrode electrolyte in the positive electrode active material layer.

In the present disclosure, it is defined that in the at least one vertical section, the total length of the contact interface between the positive electrode active material and the positive electrode active material is the total length L₂ of the second type of contact interface. In the positive electrode active material layer, the positive electrode active material and the positive electrode active material are in contact with each other, and the contact position provides a transmission channel for electrons in the positive electrode plate, but excessively high electronic conductivity can exacerbate side reactions of the electrolyte and increase the resistance of the positive electrode plate. Therefore, it is necessary to control the contact area between the positive electrode active material and the positive electrode active material to ensure that the positive electrode plate has a relatively low resistance and a certain electronic conductivity. For convenience of characterization, the present disclosure uses the length of the contact interface between the positive electrode active material and the positive electrode active material in the vertical section of the positive electrode active material layer to evaluate, and statistically calculates the total length of the contact interface between the positive electrode active material and the positive electrode active material in the vertical section to reflect the contact state between the positive electrode active material and the positive electrode active material in the positive electrode active material layer.

In the present disclosure, it is defined that in the at least one vertical section, the total length of the contact interface between the positive electrode active material and the pores is the total length L₃ of the third type of contact interface. Referring to FIG. 2, the positive electrode active material and the pores are in contact with each other, i.e., a part of the positive electrode active material is exposed in the pores and constitutes a complete pore boundary with other particles, and the part of the positive electrode active material which participates in the formation of the pore boundary and is exposed in the pores is the contact interface between the positive electrode active material and the pores, i.e., the third type of contact interface. In the positive electrode active material layer, mixing, coating and other processes can lead to pores in the positive electrode active material layer, and the pores cannot participate in the construction of ion pathways and electron pathways and cannot contribute to the electrochemical performance of the positive electrode plate. Controlling the total area of the type of contact between the positive electrode active material and the pores in a small range can reduce the adverse effects of the pores on the positive electrode plate. The contact condition between the positive electrode active material and the pores is evaluated by using the length of the contact interface between the positive electrode active material and the pores in the vertical section of the positive electrode active material layer, and the total length of the contact interface between the positive electrode active material and the pores in the vertical section is statistically calculated to reflect the contact state between the positive electrode active material and the pores in the positive electrode active material layer.

In the present disclosure, the length ratio of the total length L₁ of the first type of contact interface, the total length L₂ of the second type of contact interface, and the total length L₃ of the third type of contact interface satisfies: L₁:L₂:L₃=(80-99):(1-20):(0-5), and wherein L1, L2, and L3 are defined on a normalized scale in which their sum is taken as 100. Specifically, the length ratio of the total length L₁ of the first type of contact interface, the total length L₂ of the second type of contact interface, and the total length L₃ of the third type of contact interface can be, but is not limited to, 80:(1-20):(0-5), 85:(1-20):(0-5), 90:(1-20):(0-5), 95:(1-20):(0-5), 99:(1-20):(0-5), (80-99):5:(0-5), (80-99):15:(0-5), (80-99):20:(0-5), (80-99):(1-20):0, (80-99):(1-20):2, or (80-99):(1-20):5, etc. In an embodiment of the present disclosure, the length ratio of the total length L₁ of the first type of contact interface, the total length L₂ of the second type of contact interface, and the total length L₃ of the third type of contact interface satisfies: L₁:L₂:L₃=(85-95):(5-10):(0-2), which can improve the ionic conductivity and specific capacity of the positive electrode plate.

In an embodiment of the present disclosure, the positive electrode active material can aggregate a large number of ions, thereby improving the ionic conductivity and electronic conductivity of the positive electrode plate. Specifically, the positive electrode active material can include, but is not limited to, at least one of lithium iron phosphate, lithium cobalt oxide, lithium manganese oxide, lithium nickel cobalt aluminum oxide, and lithium nickel cobalt manganese oxide. In an embodiment of the present disclosure, the positive electrode active material can be lithium iron phosphate. In another embodiment of the present disclosure, the positive electrode active material can be lithium manganese oxide.

In an embodiment of the present disclosure, the positive electrode electrolyte provides sites for the deintercalation and intercalation of ions, thereby increasing the number of ion pathways. Specifically, the positive electrode electrolyte can include, but is not limited to, at least one of an oxide electrolyte, a sulfide electrolyte, and a polymer electrolyte. Exemplarily, the sulfide electrolyte can include, but is not limited to, at least one of Li₃PS₄, Li_{5.5}PS_{4.5}Cl_{1.5}, Li₇P₃S₁₁, Li₁₁GeP₂S₁₂, Li₆PS₅Cl, Li₇P₂S₈I, Li₁₀SnP₂S₁₂ and Li_{3.25}Ge_{0.25}P_{0.75}S₄. In an embodiment of the present disclosure, when the positive electrode electrolyte is the sulfide electrolyte, the positive electrode electrolyte is Li₁₁GeP₂S₁₂. In another embodiment of the present disclosure, the positive electrode electrolyte can be the oxide electrolyte. In an embodiment of the present disclosure, the positive electrode current collector can include, but is not limited to, at least one of copper, aluminum, nickel, and stainless steel. In an embodiment of the present disclosure, the positive electrode current collector can be an aluminum foil.

In an embodiment of the present disclosure, the positive electrode active material layer further includes a binder, which can enhance the binding ability between the positive electrode active material layer and the positive electrode current collector. Specifically, the binder can include, but is not limited to, at least one of polyvinylidene fluoride, polyvinylidene difluoride, polytetrafluoroethylene, polyethylene, polypropylene, polystyrene, polybutadiene, acrylic resin, epoxy resin, polyethylene oxide, sodium carboxymethyl cellulose, and styrene-butadiene latex. In an embodiment of the present disclosure, the binder can be sodium carboxymethyl cellulose. In another embodiment of the present disclosure, the binder can be epoxy resin.

In an embodiment of the present disclosure, the mass percentage of the positive electrode active material in the positive electrode active material layer ranges from 50% to 90%. Specifically, the mass percentage of the positive electrode active material in the positive electrode active material layer can be, but is not limited to, 50%, 55%, 60%, 70%, 80%, or 90%, etc. In an embodiment of the present disclosure, the mass percentage of the positive electrode active material in the positive electrode active material layer ranges from 50% to 75%. In another embodiment of the present disclosure, the mass percentage of the positive electrode active material in the positive electrode active material layer ranges from 70% to 90%.

In an embodiment of the present disclosure, the D50 particle size of the positive electrode active material ranges from 2 µm to 6 µm, which can improve the specific capacity and ionic conductivity of the positive electrode plate. Specifically, the D50 particle size of the positive electrode active material can be, but is not limited to, 2 µm, 3 µm, 4 µm, 5 µm, or 6 µm, etc. In an embodiment of the present disclosure, the D50 particle size of the positive electrode active material ranges from 2 µm to 4 µm. In another embodiment of the present disclosure, the D50 particle size of the positive electrode active material ranges from 3 µm to 6 µm.

In an embodiment of the present disclosure, the mass percentage of the positive electrode electrolyte in the positive electrode active material layer ranges from 10% to 50%. Specifically, the mass percentage of the positive electrode electrolyte in the positive electrode active material layer can be, but is not limited to, 10%, 15%, 20%, 25%, 30%, 35%, 40%, or 50%, etc. In an embodiment of the present disclosure, the mass percentage of the positive electrode electrolyte in the positive electrode active material layer ranges from 10% to 45%. In another embodiment of the present disclosure, the mass percentage of the positive electrode electrolyte in the positive electrode active material layer ranges from 20% to 50%.

In an embodiment of the present disclosure, the D50 particle size of the positive electrode electrolyte ranges from 1 µm to 5 µm, which can improve the specific capacity and ionic conductivity of the positive electrode plate. Specifically, the D50 particle size of the positive electrode electrolyte can be, but is not limited to, 1 µm, 2 µm, 3 µm, 4 µm, or 5 µm, etc. In an embodiment of the present disclosure, the D50 particle size of the positive electrode electrolyte ranges from 1 µm to 4 µm. In another embodiment of the present disclosure, the D50 particle size of the positive electrode electrolyte ranges from 2 µm to 5 µm.

In an embodiment of the present disclosure, the mass ratio of the positive electrode active material to the positive electrode electrolyte is 1:(0.1-1). Specifically, the mass ratio of the positive electrode active material to the positive electrode electrolyte can be, but is not limited to, 1:0.1, 1:0.2, 1:0.4, 1:0.5, 1:0.7, 1:0.8, 1:0.9, or 1:1, etc. In an embodiment of the present disclosure, the mass ratio of the positive electrode active material to the positive electrode electrolyte can be 1:(0.1-0.5). In another embodiment of the present disclosure, the mass ratio of the positive electrode active material to the positive electrode electrolyte can be 1:(0.3-1).

In an embodiment of the present disclosure, the pore size of the pores ranges from 0.1 µm to 5 µm. The pore size of the pores is smaller, the total length L₃ of the third type of contact interface can be reduced, and the adverse effect of the pores on the positive electrode plate can be reduced. Specifically, the pore size of the pores can be, but is not limited to, 0.1 µm, 1 µm, 2 µm, 3 µm, 4 µm, or 5 µm, etc. In an embodiment of the present disclosure, the pore size of the pores ranges from 0.1 µm to 3 µm. In another embodiment of the present disclosure, the pore size of the pores ranges from 2 µm to 5 µm. The volume and the pore size of the pores can be measured by means of SEM images.

In an embodiment of the present disclosure, the volume percentage of the pores in the positive electrode active material layer is less than or equal to 5%. The pore volume in the positive electrode active material layer is smaller, the total length L₃ of the third type of contact interface can be reduced, thereby improving the electrochemical performance of the positive electrode plate. Specifically, the volume percentage of the pores in the positive electrode active material layer can be, but is not limited to, less than or equal to 5%, less than or equal to 4.5%, less than or equal to 3%, less than or equal to 3.5%, or less than or equal to 2%, etc. In an embodiment of the present disclosure, the volume percentage of the pores in the positive electrode active material layer can be less than or equal to 3.5%.

The present disclosure also provides a method for evaluating an electrochemical performance of a positive electrode plate, including:
providing the positive electrode plate, the positive electrode plate including the positive electrode current collector and the positive electrode active material layer arranged on the surface of the positive electrode current collector, the positive electrode active material layer including the positive electrode active material and the positive electrode electrolyte, and pores existing in the positive electrode active material layer;
cutting the positive electrode plate along a thickness direction of the positive electrode plate to obtain a vertical section of the positive electrode active material layer; taking at least one vertical section of the positive electrode active material layer, and defining that, in the at least one vertical section, the total length of the contact interface between the positive electrode active material and the positive electrode electrolyte is the total length L₁ of the first type of contact interface, the total length of the contact interface between the positive electrode active material and the positive electrode active material is the total length L₂ of the second type of contact interface, and the total length of the contact interface between the positive electrode active material and the pores is the total length L₃ of the third type of contact interface;
acquiring the total length L₁ of the first type of contact interface, the total length L₂ of the second type of contact interface and the total length L₃ of the third type of contact interface in the vertical section of the positive electrode active material layer by a characterization means, and calculating the ratio L₁:L₂:L₃ of the total length L₁ of the first type of contact interface, the total length L₂ of the second type of contact interface and the total length L₃ of the third type of contact interface, and evaluating the electrochemical performance of the positive electrode plate by determining whether L₁:L₂:L₃ satisfies L₁:L₂:L₃=(80-99):(1-20):(0-5), and wherein L1, L2, and L3 are defined on a normalized scale in which their sum is taken as 100.

The method for evaluating the electrochemical performance of the positive electrode plate is novel, simple in evaluation process, wide in application range and capable of rapidly evaluating the electrochemical performance of the positive electrode plate.

In an embodiment of the present disclosure, the positive electrode plate is cut along the thickness direction of the positive electrode plate by an ion grinder to obtain the vertical section of the positive electrode active material layer; at least one vertical section of the positive electrode active material layer is taken, and it is defined that in the at least one vertical section, the total length of the contact interface between the positive electrode active material and the positive electrode electrolyte is the total length L₁ of the first type of contact interface, the total length of the contact interface between the positive electrode active material and the positive electrode active material is the total length L₂ of the second type of contact interface, and the total length of the contact interface between the positive electrode active material and pores is the total length L₃ of the third type of contact interface; the particle distribution characterization of the vertical section of the positive electrode active material layer is acquired by an analysis software or manual calculation, the total length L₁ of the contact interface between the positive electrode active material and the positive electrode electrolyte, the total length L₂ of the contact interface between the positive electrode active material and the positive electrode active material, and the total length L₃ of the contact interface between the positive electrode active material and pores are acquired, and wherein L1, L2, and L3 are defined on a normalized scale in which their sum is taken as 100, the ratio L₁:L₂:L₃ of the three is calculated, and the electrochemical performance of the positive electrode plate is evaluated by determining whether L₁:L₂:L₃ satisfies L₁:L₂:L₃=(80-99):(1-20):(0-5). If L₁:L₂:L₃ satisfies L₁:L₂:L₃=(80-99):(1-20):(0-5), the positive electrode plate has high ionic conductivity, high specific capacity and low resistance, and has excellent comprehensive electrochemical performance. If L₁:L₂:L₃ does not satisfy L₁:L₂:L₃=(80-99):(1-20):(0-5), the positive electrode plate has poor ionic conductivity, low specific capacity and high resistance, and has poor comprehensive electrochemical performance.

In the present disclosure, at least one vertical section of the positive electrode active material layer is taken to perform the proportion statistics of the total length of the first type of contact interface, the total length of the second type of contact interface and the total length of the third type of contact interface. The at least one vertical section can be one or more (two or more) vertical sections. Taking a plurality of vertical sections for statistical analysis is conducive to more accurately evaluating the electrochemical performance of the positive electrode plate. The vertical section can be a vertical section along the length direction of the positive electrode active material layer, or a vertical section along the width direction of the positive electrode active material layer, or a vertical section passing through the central axis of the positive electrode active material layer. In some embodiments of the present disclosure, the vertical section of the positive electrode active material layer can be obtained by cutting through the central axis of the positive electrode active material layer. When a plurality of cuts are performed and the cutting interval is small enough to obtain a sufficient number of vertical sections, the statistical precision of various contact situations in the positive electrode plate can be further improved, and the acquired ratio L₁:L₂:L₃ is also closer to the real total area ratio of the three types of contacts in the positive electrode active material layer.

The present disclosure also provides a positive electrode plate, the positive electrode plate includes a positive electrode active material layer, the positive electrode active material layer includes a positive electrode active material and a positive electrode electrolyte, and pores exist in the positive electrode active material layer; it is defined that in the positive electrode active material layer, the contact area between the positive electrode active material and the positive electrode electrolyte is the total area S₁ of the first type of contact interface, the contact area between the positive electrode active material and the positive electrode active material is the total area S₂ of the second type of contact interface, and the contact area between the positive electrode active material and the pores is the total area S₃ of the third type of contact interface, wherein the area ratio of the total area S₁ of the first type of contact interface, the total area S₂ of the second type of contact interface and the total area S₃ of the third type of contact interface satisfies S₁:S₂:S₃=(80-99):(1-20):(0-5), and wherein S1, S2, and S3 are defined on a normalized scale in which their sum is taken as 100.

The positive electrode plate provided by the present disclosure has a high proportion of the total area S₁ of the first type of contact interface, i.e., the contact interface between the positive electrode active material and the positive electrode electrolyte in the active material layer is large, the ion transfer occurs widely, the pathways for ion intercalation and deintercalation are increased, and the ionic conductivity and specific capacity of the positive electrode plate are improved; the appropriate total area S₂ of the second type of contact interface, i.e., the contact interface between positive electrode active materials, provides an appropriate number of electronic conduction pathways and maintains a low resistance of the positive electrode plate; the total area S₃ of the third type of contact interface reflects the contact area between the positive electrode active material and the pores, the contact cannot participate in the construction of electronic conduction and ionic conduction pathways, is an ineffective contact, and cannot effectively affect the electrochemical performance of the positive electrode plate, and therefore the proportion of the total area S₃ of the third type of contact interface is low. In the positive electrode plate provided by the present disclosure, by controlling the proportion range of three types of contacts in the positive electrode active material layer, i.e., the contact area between the positive electrode active material and the positive electrode electrolyte, the contact area between the positive electrode active material and the positive electrode active material, and the contact area between the positive electrode active material and pores, the number of ionic conduction pathways in the positive electrode plate can be increased, the appropriate number of electronic conduction pathways can be controlled, the ionic conductivity and specific capacity are improved, the resistance of the positive electrode plate is reduced, and thus the comprehensive electrochemical performance of the positive electrode plate is improved.

The present disclosure further provides a solid-state battery, the solid-state battery includes the positive electrode plate provided in any one of the above embodiments and a solid-state electrolyte layer arranged on a surface of the positive electrode plate. The solid-state battery provided by the present disclosure has a high specific capacity, good safety performance, and excellent electrochemical performance. Referring to FIG. 3, FIG. 3 is a schematic diagram of a section structure of a solid-state battery provided by an embodiment of the present disclosure, the solid-state battery includes a positive electrode plate 10, an negative electrode plate 30, and a solid-state electrolyte layer 20 arranged between the positive electrode plate 10 and the negative electrode plate 30, and the negative electrode plate 30 includes a negative electrode current collector 32 and a negative electrode active material layer 31 arranged on a surface of the negative electrode current collector 32.

In one embodiment of the present disclosure, the solid-state electrolyte layer can improve the safety of the solid-state battery, and the solid-state electrolyte layer includes a solid-state electrolyte and a binder. The binder can improve the bonding ability of the components in the solid-state electrolyte layer and improve the bonding ability between the solid-state electrolyte layer and the negative electrode and positive electrode plates. Specifically, the binder can be, but is not limited to, at least one of polyvinylidene fluoride, polyvinylidene difluoride, polytetrafluoroethylene, polyethylene, polypropylene, polystyrene, polybutadiene, acrylic resin, epoxy resin, polyethylene oxide, sodium carboxymethyl cellulose, and styrene-butadiene latex. In one embodiment of the present disclosure, the binder may be polyvinylidene fluoride. In another embodiment of the present disclosure, the binder may be sodium carboxymethyl cellulose.

In one embodiment of the present disclosure, the solid-state electrolyte can include, but is not limited to, at least one of an organic polymer, an oxide, and a sulfide. The organic polymer can include, but is not limited to, at least one of polyethylene oxide, polypropylene oxide, polyvinylidene chloride, and polyvinylidene fluoride; the oxide can include, but is not limited to, at least one of lithium lanthanum titanium oxide, lithium lanthanum zirconium oxide, and fast ion conductors; and the sulfide can include, but is not limited to, at least one of a lithium-containing sulfide, an aluminum-containing sulfide, a phosphorus-containing sulfide, a silicon-containing sulfide, and a tin-containing sulfide. In one embodiment of the present disclosure, the solid-state electrolyte may be the lithium-containing sulfide, and the lithium-containing sulfide electrolyte can include, but is not limited to, at least one of Li₃PS₄, Li_{5.5}PS_{4.5}Cl_{1.5}, Li₇P₃S₁₁, Li₁₁GeP₂S₁₂, Li₆PS₅Cl, Li₇P₂S₈I, Li₁₀SnP₂S₁₂ and Li_{3.25}Ge_{0.25}P_{0.75}S₄. In another embodiment of the present disclosure, the solid-state electrolyte may be polypropylene oxide.

In one embodiment of the present disclosure, the particle size of the solid-state electrolyte particles ranges from 1 nm to 5 µm. Specifically, the particle size of the solid-state electrolyte particles can be, but is not limited to, 1 nm, 20 nm, 100 nm, 1.5 µm, 2 µm, 3 µm, or 5 µm, etc. In one embodiment of the present disclosure, the particle size of the solid-state electrolyte particles ranges from 1nm to 500 nm. In another embodiment of the present disclosure, the particle size of the solid-state electrolyte particles ranges from 1 µm to 5 µm.

In one embodiment of the present disclosure, the negative electrode may be selected from conventional negative electrodes such as a graphite negative electrode, a silicon-based negative electrode, and lithium metal.

In one embodiment of the present disclosure, the negative electrode active material layer includes the negative electrode active material, and the negative electrode active material can include, but is not limited to, at least one of silicon, tin, germanium, lithium and alloys thereof, and carbon materials. The carbon material can include, but is not limited to, at least one of non-graphitized carbon, graphite, pyrolytic carbon, coke, activated carbon, or acetylene black. In one embodiment of the present disclosure, the negative electrode active material may be the carbon material. In another embodiment of the present disclosure, the negative electrode active material may be the silicon material.

In one embodiment of the present disclosure, when the negative electrode active material includes the silicon material, the negative electrode active material layer further includes a conductive agent. The conductive agent can increase the electrical conductivity between active materials and improve the electronic conductivity. Specifically, the conductive agent can include, but is not limited to, at least one of graphite, carbon black, acetylene black, and graphene. In one embodiment of the present disclosure, the conductive agent may be graphite. In another embodiment of the present disclosure, the conductive agent may be carbon black.

In one embodiment of the present disclosure, the negative electrode current collector can include, but is not limited to, at least one of copper, aluminum, nickel, and stainless steel. In one embodiment of the present disclosure, the negative electrode current collector may be a copper foil.

The present disclosure also provides an electric device, and the electric device includes the solid-state battery according to any one of the above embodiments. The electric device provided by the present disclosure has excellent comprehensive performance and strong market competitiveness. The electric device includes a mobile phone, a tablet, a watch, VR glasses, a vehicle, etc. In an embodiment of the present disclosure, the solid-state battery can be used in a vehicle, thereby improving the safety of electricity usage of the vehicle. In another embodiment of the present disclosure, the solid-state battery can also be used in a mobile phone, thereby increasing the battery capacity of the mobile phone and improving the service life of the battery.

The effects of the technical solutions of the present disclosure are further described below through specific examples.

### Example 1

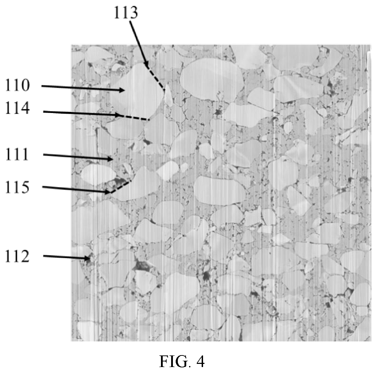

1. The positive electrode plate: the positive electrode active material (single crystal of (LiNi_{0.8}Co_{0.1}Mn_{0.1}O₂) with a D50 particle size of 4 µm) and the positive electrode electrolyte (Li_{5.5}PS_{4.5}Cl_{1.5} with a particle size of 1 µm) are mixed, the mass ratio of the positive electrode active material to the positive electrode electrolyte is 4:1, a mixed slurry is obtained, the mixed slurry is coated on the surface of the positive electrode current collector to obtain the positive electrode plate, and a vertical section of the positive electrode active material layer along the thickness direction is randomly taken. FIG. 4 is a scanning electron microscope (SEM) image of the section of the positive electrode active material layer provided by the Example 1 of the present disclosure. The positive electrode active material layer 11 includes the positive electrode active material 110 and the positive electrode electrolyte 111, and pores 112 exist in the positive electrode active material layer; the contact interface of the positive electrode active material 110 and the positive electrode electrolyte 111 is the first type of contact interface 113, the contact interface of the positive electrode active material 110 and the positive electrode active material 110 is the second type of contact interface 114, and the contact interface of the positive electrode active material 110 and the pores 112 is the third type of contact interface 115. The lengths of the three types of contact interfaces in the whole section are statistically calculated, and the length ratio of the total length L₁ of the first type of contact interface, the total length L₂ of the second type of contact interface, and the total length L₃ of the third type of contact interface is 88:10:2.
2. The negative electrode plate: a lithium copper composite foil with a thickness of 20 µm is taken and cut into the negative electrode plate in the present disclosure.
3. The solid-state electrolyte layer: 980 g of lithium-containing sulfide electrolyte LPSCl is placed into 600 g of a xylene solution, wherein the xylene solution contains 20 g of butadiene rubber binder, and then heated and stirred to obtain a stable and uniform solution. The solution is continuously coated on a release film, and then dried at 333 K to obtain a self-supporting electrolyte film with a thickness of 40 µm, which is cut into the electrolyte layer plate.

### Example 2

The difference from the Example 1 is that the length ratio of the total length L₁ of the first type of contact interface, the total length L₂ of the second type of contact interface, and the total length L₃ of the third type of contact interface is 93:5:2.

### Example 3

The difference from the Example 1 is that the length ratio of the total length L₁ of the first type of contact interface, the total length L₂ of the second type of contact interface, and the total length L₃ of the third type of contact interface is 80:18:2.

### Example 4

The difference from the Example 1 is that the length ratio of the total length L₁ of the first type of contact interface, the total length L₂ of the second type of contact interface, and the total length L₃ of the third type of contact interface is 85:10:5.

### Example 5

The difference from the Example 1 is that the length ratio of the total length L₁ of the first type of contact interface, the total length L₂ of the second type of contact interface, and the total length L₃ of the third type of contact interface is 98:1:1.

### Comparative Example 1

The difference from the Example 1 is that the length ratio of the total length L₁ of the first type of contact interface, the total length L₂ of the second type of contact interface, and the total length L₃ of the third type of contact interface is 80:10:10.

### Comparative Example 2

The difference from the Example 1 is that the length ratio of the total length L₁ of the first type of contact interface, the total length L₂ of the second type of contact interface, and the total length L₃ of the third type of contact interface is 55:30:15.

### Performance test

The positive electrode plate and the negative electrode plate prepared in the above examples and comparative examples and the solid-state electrolyte layer are used to form a solid-state battery, and battery performance is tested. The test method is as follows: 5 solid-state batteries prepared in each of the examples and comparative examples are taken, and the solid-state batteries are respectively subjected to charge-discharge cycle test at a 0.1C rate on a LAND CT 2001C secondary battery performance testing device, and the specific capacity of the positive electrode plate is calculated and recorded as Q1. Then, the solid-state batteries are subjected to charge-discharge test at a 0.5C rate, and the specific capacity is recorded as Q2, and the 0.5C/0.1C capacity retention rate is Q1/Q2*100%, recorded as the rate performance. The step is repeated, and when the battery capacity is lower than 80% of the initial discharge capacity during the cycle process, the cycle is terminated, and the cycle number is the cycle life of the solid-state battery. The results are shown in Table 1.

**Table 1 Battery performance test results**

| | Specific capacity (mAh/g) | Rate performance (%) | Cycle life (cycles) |
|---|---|---|---|
| Example 1 | 202 | 93.7 | 178 |
| Example 2 | 208 | 87.2 | 174 |
| Example 3 | 197 | 94.1 | 159 |
| Example 4 | 195 | 84.7 | 151 |
| Example 5 | 211 | 82.6 | 192 |
| Comparative Example 1 | 192 | 88.5 | 147 |
| Comparative Example 2 | 172 | 77.1 | 82 |

As can be seen from the data in Table 1, compared with Comparative Examples 1 and 2, the positive electrode plates prepared in the Examples 1 to 5 have high specific capacity, excellent rate performance, long cycle life and good comprehensive performance. This is because, in the Examples 1 to 5, the length ratio of the total length L₁ of the first type of contact interface, the total length L₂ of the second type of contact interface and the total length L₃ of the third type of contact interface satisfies: L₁:L₂:L₃=(80-99):(1-20):(0-5), which can ensure that the positive electrode plate has a large number of ionic conduction pathways and an appropriate number of electronic conduction pathways, effectively improve the ionic conductivity and specific capacity, and reduce the resistance of the positive electrode plate. Comparative Examples 1 and 2 do not satisfy the above range, and thus batteries with excellent comprehensive performance cannot be obtained.

In addition, as can be seen from the results of the Examples 1 to 5, under the condition of satisfying L₁:L₂:L₃=(80-99):(1-20):(0-5), maintaining a high proportion of the total length L₁ of the first type of contact interface while appropriately increasing the proportion of the total length L₂ of the second type of contact interface and reducing the proportion of the total length L₃ of the third type of contact interface is conducive to better balancing the ionic conductivity and the electronic conductivity, so that the positive electrode plate can better balance the high specific capacity, the rate performance and the cycle performance.

The above are the specific embodiments of the present disclosure, but it cannot be understood as the limitation of the scope of the present disclosure. It should be pointed out that for a person skilled in the art, several improvements and modifications can be made without departing from the principle of the present disclosure, and these improvements and modifications are also regarded as the protection scope of the present disclosure.

## Claims

1. A positive electrode plate, the positive electrode plate (10) comprising a positive electrode current collector (12) and a positive electrode active material layer (11) arranged on a surface of the positive electrode current collector (12), the positive electrode active material layer (11) comprising a positive electrode active material (110) and a positive electrode electrolyte (111), and pores (112) existing in the positive electrode active material layer (11);
taking at least one vertical section of the positive electrode active material layer (11) along a thickness direction, defining that in the at least one vertical section, a total length of a contact interface between the positive electrode active material (110) and the positive electrode electrolyte (111) is a total length L₁ of a first type of contact interface (113), a total length of a contact interface between the positive electrode active material (110) and the positive electrode active material (110) is a total length L₂ of a second type of contact interface (114), and a total length of a contact interface between the positive electrode active material (110) and the pores (112) is a total length L₃ of a third type of contact interface (115);
a length ratio of the total length L₁ of the first type of contact interface (113), the total length L₂ of the second type of contact interface (114), and the total length L₃ of the third type of contact interface (115) satisfying: L₁:L₂:L₃ = (80-99):(1-20):(0-5), and wherein L1, L2, and L3 are defined on a normalized scale in which their sum is taken as 100.

2. The positive electrode plate according to claim 1, wherein the length ratio of the total length L₁ of the first type of contact interface (113), the total length L₂ of the second type of contact interface (114), and the total length L₃ of the third type of contact interface (115) satisfies: L₁:L₂:L₃=(85-95):(5-15):(0-2), and wherein L1, L2, and L3 are defined on a normalized scale in which their sum is taken as 100.

3. The positive electrode plate according to any one of claims 1 and 2, wherein a mass percentage of the positive electrode active material (110) in the positive electrode active material layer (11) ranges from 50% to 90%, and a mass percentage of the positive electrode electrolyte (111) in the positive electrode active material layer (11) ranges from 10% to 50%.

4. The positive electrode plate according to any one of claims 1 to 3, wherein a volume percentage of the pores (112) in the positive electrode active material layer (11) is less than or equal to 5%, and a pore size of the pores (112) ranges from 0.1 µm to 5 µm.

5. The positive electrode plate according to any one of claims 1 to 4, wherein the positive electrode active material (110) comprises at least one of lithium iron phosphate, lithium cobalt oxide, lithium manganese oxide, lithium nickel cobalt aluminum oxide, lithium nickel cobalt manganese oxide, and lithium nickel manganese oxide, and the positive electrode electrolyte (111) comprises at least one of an oxide electrolyte, a sulfide electrolyte, and a polymer electrolyte.

6. The positive electrode plate according to claim 5, wherein the sulfide electrolyte comprises at least one of Li₃PS₄, Li_{5.5}PS_{4.5}Cl_{1.5}, Li₇P₃S₁₁, Li₁₁GeP₂S₁₂, Li₆PS₅Cl, Li₇P₂S₈I, Li₁₀SnP₂S₁₂ and Li_{3.25}Ge_{0.25}P_{0.75}S₄.

7. A method for evaluating an electrochemical performance of a positive electrode plate, comprising:
providing a positive electrode plate (10), the positive electrode plate (10) comprising a positive electrode current collector (12) and a positive electrode active material layer (11) arranged on a surface of the positive electrode current collector (12), the positive electrode active material layer (11) comprising a positive electrode active material (110) and a positive electrode electrolyte (111), and pores (112) existing in the positive electrode active material layer (11);
cutting the positive electrode plate (10) along a thickness direction of the positive electrode plate (10) to obtain a vertical section of the positive electrode active material layer (11); taking at least one vertical section of the positive electrode active material layer (11), and defining that in the at least one vertical section, a total length of a contact interface between the positive electrode active material (110) and the positive electrode electrolyte (111) is a total length L₁ of a first type of contact interface (113), a total length of a contact interface between the positive electrode active material (110) and the positive electrode active material (110) is a total length L₂ of a second type of contact interface (114), and a total length of a contact interface between the positive electrode active material (110) and the pores (112) is a total length L₃ of a third type of contact interface (115);
acquiring the total length L₁ of the first type of contact interface (113), the total length L₂ of the second type of contact interface (114), and the total length L₃ of the third type of contact interface (115) in the vertical section of the positive electrode active material layer (11) by a characterization means, and calculating a ratio L₁:L₂:L₃ of the total length L₁ of the first type of contact interface (113), the total length L₂ of the second type of contact interface (114), and the total length L₃ of the third type of contact interface (115), and evaluating the electrochemical performance of the positive electrode plate (10) by determining whether L₁:L₂:L₃ satisfies L₁:L₂:L₃=(80-99):(1-20):(0-5), and wherein L1, L2, and L3 are defined on a normalized scale in which their sum is taken as 100.

8. A positive electrode plate, the positive electrode plate (10) comprising a positive electrode active material layer (11), the positive electrode active material layer (11) comprising a positive electrode active material (110) and a positive electrode electrolyte (111), and pores (112) existing in the positive electrode active material layer (11);
defining that, in the positive electrode active material layer (11), a total area of a contact interface between the positive electrode active material (110) and the positive electrode electrolyte (111) is a total area S₁ of a first type of contact interface (113), a total area of a contact interface between the positive electrode active material (110) and the positive electrode active material (110) is a total area S₂ of a second type of contact interface (114), and a total area of a contact interface between the positive electrode active material (110) and the pores (112) is a total area S₃ of a third type of contact interface (115);
an area ratio of the total area S₁ of the first type of contact interface (113), the total area S₂ of the second type of contact interface (114), and the total area S₃ of the third type of contact interface (115) satisfying S₁:S₂:S₃=(80-99):(1-20):(0-5), and wherein S1, S2, and S3 are defined on a normalized scale in which their sum is taken as 100.

9. A solid-state battery, the solid-state battery comprising a positive electrode plate (10) and a solid-state electrolyte layer (20) arranged on a surface of the positive electrode plate (10), and the positive electrode plate (10) comprising the positive electrode plate according to any one of claims 1 to 6 or claim 8.

10. The solid-state battery according to claim 9, wherein the solid-state electrolyte layer (20) comprises at least one of an oxide electrolyte, a sulfide electrolyte, and a polymer electrolyte.

11. An electric device, the electric device comprising the solid-state battery according to any one of claims 9 and 10.
